# EUROPÄISCHE PATENTSCHRIFT

(11) **EP 1 171 379 B1**
(45) Veröffentlichungstag und Bekanntmachung des Hinweises auf die Patenterteilung: **22.03.2006**
(21) Anmeldenummer: 00922565.7
(22) Anmeldetag: 29.03.2000
(51) Int. Cl.: C01B 7/19, C01C 1/16, C09K 13/08, H01L 21/306

(54) **VERFAHREN ZUR HERSTELLUNG HOCHREINER LÖSUNGEN UNTER VERWENDUNG VON GASFÖRMIGEM FLUORWASSERSTOFF**
METHOD FOR PRODUCING HIGH-PURITY SOLUTIONS USING GASEOUS HYDROGEN FLUORIDE
PROCEDE DE PRODUCTION DE SOLUTIONS DE HAUTE PURETE AU MOYEN D'ACIDE FLUORHYDRIQUE GAZEUX

(30) Priorität: 29.03.1999 DE 19914243
(43) Veröffentlichungstag der Anmeldung: 16.01.2002
(73) Patentinhaber: Honeywell Specialty Chemicals Seelze GmbH, 30926 Seelze (DE)
(72) Erfinder: SIEVERT, Wolfgang, D-31515 Wunstorf (DE)
(74) Vertreter: Bublak, Wolfgang
(86) Internationale Anmeldenummer: PCT/EP2000/002763
(87) Internationale Veröffentlichungsnummer: WO 2000/058208

(56) Entgegenhaltungen:
- EP-A- 0 679 607
- EP-A- 0 887 323
- WO-A-97/02958
- CH-A- 664 978
- DD-A- 281 173
- US-A- 3 979 241
- US-A- 4 230 523
- US-A- 4 269 654
- US-A- 5 336 356

## Beschreibung

Die vorliegende Erfindung betrifft ein Verfahren zur Herstellung einer hochreinen, Fluorwasserstoff oder ein Salz davon oder ein Gernisch aus zwei oder mehr davon enthaltenden Lösung, bei dem in einem Schritt Fluorwasserstoff in ein polares und serfreies Lösungsmittel eingeleitet wird, wobei der verwendete Fluorwasserstoff als Gas oder/und als verflüssigtes Gas eingesetzt wird Ebenso betrifft die vorliegende Erfindung die Verwendung der erfindungsgemäß hergestellten hochreinen Lösung als Ätzmittel.

In einer Reihe von industriellen Anwendungsgebieten, unter denen beispielsweise die Elektronik- und Halbleiterindustrie zu nennen sind, besteht das Erfordernis, hochreine Lösungen einzusetzen. Unter diesen Lösungen sind unter anderem solche zu nennen, die, neben gegebenfalls weiteren Edukten, aus Fluorwasserstoff hergestellt werden . EP-A -887 393und US- A -4230523 bescheiben wassecheltige lösungen; WO -A -97/02958, 00-A-281 173 und US -A - 1979241 bescheiben wassesfreie System.

Eine Aufgabe der vorliegenden Erfindung war es daher, ein Verfahren bereitzustellen, das es erlaubt, solche hochreinen Lösungen, bei deren Herstellung Fluorwasserstoff eingesetzt wird, auf einfache Art und Weise zu produzieren.

Daher betrifft die vorliegende Erfindung ein Verfahren zur Herstellung einer hochreinen, Fluorwasserstoff oder ein Salz davon oder ein Gemisch aus zwei oder mehr davon enthaltenden Lösung, das den folgenden Schritt (i) umfaßt:
(i) Einleiren von Fluorwasserstoff in mindestens ein polares Lösungsmit-tel, das dadurch gekennzeichnet ist, daß Fluorwasserstoff als Gas oder/und verflüssigtes Gas in das mindestens eine wasserfreie Lösungsmittel eingeleitet wird.

Das Einleiten des Fluorwasserstoffs als Gas oder/und als verflüssigtes Gas kann hierbei nach allen dazu geeigneten Verfahren nach dem Stand der Technik durchgeführt werden.

In einer bevorzugten Ausführungsform wird dabei das mindestens eine wasserfreie Lösungsmittel in einem geeigneten Behälter vorgelegt. Die Behältermaterialien können hierbei aus allen für das Verfahren geeigneten Materialien gefertigt sein, die die Hochreinheit der Lösung gewährleisten. Bevorzugt sind hierbei Behälter, deren Innenwände, die mit der hochreinen Lösung in Kontakt stehen, aus metallfreien Polymeren wie etwa HDPE, PFA, Polypropylen, PVDF und perfluoriertes Polyethylenpropylen (FEP) gefertigt sind.

Unter diesen sind hierbei unstabilisierte HD-Polyethylene wie beispielsweise HD-Polyethylene mit einer spezifischen Dichte von 0,940 - 0,970 g/cm³, insbesondere 0,942 - 0,961 g/cm³ zu nennen. Hierzu gehören insbesondere Polyethylene, die im Handel unter dem Warenzeichen Lupolen vertrieben werden. Darunter seien Lupolen® 6021D, Lupolen® 5021D, Lupolen® 4261AQ149 und Lupolen® 4261AQ135 genannt. Die verwendeten Behälter können im erfindungsgemäßen Verfahren aus einer oder auch aus mehreren Schichten bestehen, wobei die gegebenenfalls eine oder mehreren äußeren Schichten aus allen denkbaren Materialien gefertigt sein können.

Die Zuleitungen, über die Fluorwasserstoff als Gas oder/und als verflüssigtes Gas in den Behälter, in dem das mindestens eine polare Lösungsmittel vorgelegt ist, eingeleitet wird, kann ebenfalls aus allen hierfür geeigneten Materialien bestehen. Bevorzugt werden im erfindungsgemäßen Verfahren Schlauchverbindungen eingesetzt, die aus hochreinem PFA gefertigt sind.

Sollte im Rahmen der vorliegenden Erfindung der gasförmige Fluorwasserstoff vor dem Einleiten in das mindestens eine wasserfreie Lösungsmittel verflüssigt werden, so kann diese Verflüssigung nach allen denkbaren Verfahren gemäß dem Stand der Technik erfolgen.

Ist es im Rahmen der vorliegenden Erfindung vorgesehen, den Fluorwasserstoff sowohl gasförmig als auch als verflüssigtes Gas in das mindestens eine polare Lösungsmittel einzuleiten, so ist es denkbar, zuerst gasförmigen und im Anschluß flüssigen Fluorwasserstoff einzuleiten. Ebenso kann zuerst flüssiger und im Anschluß gasförmiger Fluorwasserstoff eingeleitet werden. Weiter ist es denkbar, gasförmigen und flüssigen Fluorwasserstoff gleichzeitig einzuleiten, wobei hierbei gasförmiger und flüssiger Fluorwasserstoff vor dem Einleiten zusammengeführt werden können.

Im Rahmen der vorliegenden Erfindung ist es möglich, den Fluorwasserstoff, der als Gas oder/und als verflüssigtes Gas in das mindestens eine polare Lösungsmittel eingeleitet wird, vor dem Einleiten auf eine bestimmte gewünschte Temperatur zu bringen. Ebenso ist es möglich, das mindestens eine wasserfreie Lösungsmittel vor dem Einleiten auf eine gewünschte Temperatur zu bringen. Ebenso kann es vorgesehen werden, daß während des Einleitens von Fluorwasserstoff in das mindestens eine polare Lösungsmittel die Lösung auf eine gewünschte Temperatur gebracht oder/und auf einer gewünschten Temperatur gehalten wird. Für diese beschriebenen Temperierungen sind alle Verfahren, die aus dem Stand der Technik als geeignet bekannt sind, einsetzbar.

Während des Einleitens oder nach dem Einleiten von Fluorwasserstoff in das mindestend eine polare Lösungsmittel ist es denkbar, die Lösung zu homogenisieren. Dies ist nach allen denkbaren Methoden möglich. In einer bevorzugten Ausführungsform der vorliegenden Erfindung wird hierbei nach beendetem Ein-leiten des Fluorwasserstoffs wird die Lösung über eine oder mehrere Umpumpleitungen rezirkuliert.

Das Material oder die Materialien, aus dem diese mindestens eine Umpumpleitung gefertigt ist, unterliegt hierbei nur.der Beschränkung, daß es die Hochreinheit der Lösung gewährleistet und gegen die Lösung inert ist. Wie der Behälter, in dem sich die Lösung beendet, kann auch die mindestens eine Umpumpleitung temperierbar sein. Während des Rezirkulierens der Lösung ist es denkbar, daß, wenn erforderlich, die Temperierung der Lösung im Behälter oder/und in der mindestens einen Umpumpleitung erfolgt.

Als das mindestens eine polare Lösungsmittel können im erfindungsgemäßen Verfahren alle wasserfreien Lösungsmittel eingesetzt werden, in denen Fluorwasserstoff löslich ist.

In einer bevorzugten Ausführungsform des erfindungsgemäßen Verfahrens wird das mindestens eine polare Lösungsmittel ausgewählt aus der Gruppe beste-hend aus Polyolen, Carbonsäuren, Carbonsäurederivaten, organischen Schwefelverbindungen, aliphatischen oder aromatischen Stickstoffverbindungen und Mischungen aus zwei oder mehr davon.

Als Beispiele für die Polyole seien unter anderem Ethylenglykol, Propylenglykol, Polymethylenglykol, Polyethylenglykol oder Glycerin genannt, wobei hier insbesondere Polyole mit relativ niedriger Viskosität zu nennen sind. Weiter bevorzugt sind hier Polyalkylenglykole, insbesondere Polyethylenglykole, mit einem Zahlenmittel des Molekulargewichts von 250 bis 6000, weiter bevorzugt 250 bis unter 5000 und insbesondere 250 bis 1000, zu nennen.

Als Carbonsäuren seien aliphatische, cycloaliphatische und aromatische, unter Normalbedingungen flüssigen Säuren genannt, wobei diese eine oder mehrere Säuregruppen aufweisen können. Unter anderem sind dies hierbei Ameisensäure, Essigsäure oder Propionsäure. Ebenso sind Säurederivate der Carbonsäuren wie etwa deren Ester oder deren Amide geeignete Lösungsmittel. Weiter ist es denkbar, daß die Acylreste der Carbonsäuren oder der Carbonsäurederivate substituiert sind. Als mögliche Substituenten seien etwa Hydroxylgruppen oder Halogenidreste angeführt, Auch Aminocarbonsäuren seien hier als mögliche Lösungsmittel genannt.

Ebenso sind.wasserfreie organische Schwefelverbindungen wie etwa Sulfate, Sulfonate, Sulfoxide, Sulfone oder Sulfite geeignete Lösungsmittel. Als Beispiele seien, neben DMSO, unter anderem Dimethylsulfit, Diethylsulfit, Glycolsulfit, Dimethylsulfon, Diethylsulfon, Dipropylsulfon, Dibutylsulfon, Tetramethylensulfon, Methylsulfolan, Diethylsulfoxid, Diproylsulfoxid, Dibutylsulfoxid, Tetramethylensulfoxid, Ethylmethansulfonat, 1,4-Butandiolbis(methansulfonat), Diethylsulfat, Dipropylsulfat, Dibutylsulfat, Dihexylsulfat, Dioctylsulfat genannt.

Ebenfalls als polare Lösungsmittel im erfindungsgemäßen Verfahren geeignet sind weiter beispielsweise Ethylencarbonat, Propylencarbonat, Dimethylcarbonat, Diethylcarbonat, Dipropylcarbonat, Diisopropylcarbonat, Dibutylcarbonat.

Als Lösungsmittel sind ebenfalls Aliphaten geeignet, die dergestalt substituiert sind, daß Fluorwasserstoff in ihnen löslich ist. Als mögliche Substituenten seien unter anderem etwa Halogensubstituenten genannt.

Eine weitere Gruppe von möglichen Lösungsmitteln sind aliphatische oder aromatische Amine, die gegebenenfalls substituiert sein können. Unter diese Gruppe fallen etwa Aminoalkohole wie beispielsweise Ethanolamin.

Selbstverständlich ist es möglich, im erfindungsgemäßen Verfahren den Fluorwasserstoff zuerst in einen Teil des mindestens einen Lösungsmittel einzuleiten und nach der Einleitung weiteres Lösungsmittel zuzugeben.

Im Falle, daß im erfindungsgemäßen Verfahren zwei oder mehr verschiedene polare Lösungsmittel verwendet werden, ist es möglich, den Fluorwasser- stoff zuerst in eines oder mehr dieser Lösungsmittel einzuleiten und eines oder mehrere der anderen Lösungsmittel anschließend zuzugeben. Ebenso ist es denkbar, gemäß dem oben beschriebenen Verfahren zwei oder mehr Lösungen von Fluorwasserstoff in gegebenenfalls verschiedenen Lösungsmitteln oder Lösungsmittelgemischen herzustellen und diese zwei oder mehr Lösungen anschließend zusammenzugeben.

In einer weiter bevorzugten Ausfühnmgsform des erfindungsgemäßen Verfahrens wird ein hochreine Lösung hergestellt, wobei, neben Fluorwasserstoff und dem mindestens einen polaren Lösungsmittel, mindestens ein weiteres Edukt ein- gesetzt wird.

Demgemäß betrifft die vorliegende Erfindung auch ein Verfahren, wie oben beschrieben, das dadurch gekennzeichnet ist, daß neben Fluorwasserstoff mindestens ein weiteres Gas oder mindestens eine weitere Flüssigkeit oder mindestens ein Feststoff oder ein Gemisch aus zwei oder mehr davon dem mindestens einen polaren Lösungsmittel zugegeben wird.

Im Fall, daß das weitere Edukt mit Fluorwasserstoff nicht reagiert, ist die Reihenfolge der Zugabe der Edukte unkritisch. So ist es denkbar, das mindestens eine weitere Edukt zur Lösung aus Fluorwasserstoff in dem mindestens einen polaren Lösungsmittel zu geben. Ebenso ist es denkbar, das mindestens eine was- serfreie Lösungsmittel zuerst mit dem mindestens einen weiteren Edukt zusammenzugeben und dann Fluorwasserstoff einzuleiten. Weiterhin ist es möglich, das mindestens eine weitere Edukt zusammen mit Fluorwasserstoff dem mindestens einen polaren Lösungsmittel zuzusetzen. Gegebenenfalls kann auch der Fluorwasserstoff vor dem Einleiten in das mindestens eine polare Lösungsmittel mit dem mindestens einen weiteren Edukt gemischt werden und die resultierende Mischung dem mindestens einen polaren Lösungsmittel zugegeben werden.

In einer weiter bevorzugten Ausführungsform des erfindungsgemäßen Verfahrens wird neben Fluorwasserstoff als weiteres Edukt Ammoniak eingesetzt, wodurch eine Ammoniumfluoridlösung hergestellt wird. Dabei ist prinzipiell denkbar, daß Ammoniak als Flüssigkeit eingesetzt wird. Bevorzugt wird jedoch gasförmiger Ammoniak verwendet.

Daher betrifft die vorliegende Erfindung auch ein Verfahren zur Herstellung einer hochreinen Lösung, wie oben beschrieben, das dadurch gekennzeichnet ist, daß als das mindestens eine weitere Edukt gasförmiger Ammoniak eingesetzt wird.

Ammoniumfluoridlösungen, an die erhöhte Anforderungen hinsichtlich des Reinheitsgrades gestellt, werden, in der Regel durch Auflösen von kristallinem Ammoniumfluorid in dem entsprechenden Lösungsmittel hergestellt, wie dies beispielsweise in der US-A 5,320,709 beschrieben ist.

Ein Nachteil dieses Verfahrens ist darin zu sehen, daß die metallischen Verunreinigungen der so hergestellten Lösungen im allgemeinen im ppm-Bereich liegen und damit die Lösungen für manche Anwendungsbereiche, die wesentlich höhere Anforderungen an die Reinheit bezüglich des Metallgehaltes stellen, ungeeignet sind. Die Aufreinigung des kristallinen Ammoniumfluorids, die nötig wäre, um hochreine Lösungen herzustellen, die eine wesentlich niedrigeren Metallgehalt aufweisen, ist jedoch experimentell schwierig.

In einer bevorzugten Ausführungsform der vorliegenden Erfindung wird deshalb eine hochreine Ammoniumfluoridlösung nach dem oben beschriebenen Verfahren hergestellt.

Hierbei ist es möglich, das mindestens eine polare Lösungsmittel mit der erwünschten Menge an gasförmigem Fluorwasserstoff zu versetzen und anschließend die entsprechende Menge an gasförmigem Ammoniak einzuleiten. Ebenso ist es denkbar, das mindestens eine Lösungsmittel zuerst mit der erwünschten Menge an gasförmigem Ammoniak zu versetzen und anschließend die entsprechende Menge an gasförmigem Fluorwasserstoff einzuleiten. Die beiden gasförmigen Komponenten können auch gleichzeitig und räumlich voneinander getrennt in das mindestens eine Lösungsmittel eingeleitet werden. Gleichfalls ist es denkbar, eine der beiden gasförmigen Komponenten einzuleiten und nach einer bestimmten Zeit mit dem Einleiten der anderen gasförmigen Komponente zu beginnen.

In einer besonders bevorzugten Ausführungsform des erfindungsgemäßen Verfahrens wird das mindestens eine polare Lösungsmittel zunächst mit der gewünschten Menge an gasförmigem Fluorwasserstoff versetzt und diese Lösung, wie bereits oben beschrieben, rezirkuliert. Anschließend wird in diese homogeni-sierte Lösung gasförmiger Ammoniak eingeleitet und die resultierende Lösung wiederum durch Umpumpen rezirkuliert und damit homogenisiert.

Die Temperatur im Reaktionsgefaß wird beim Einleiten von gasförmigem Ammoniak so geregelt, daß sie höchstens 35 °C, bevorzugt höchstens 30 °C und besonders bevorzugt weniger als 30 °C beträgt.

Die Konzentrationen der hochreinen Lösungen an Ammoniumfluorid, die im Rahmen des erfindungsgemäßen Verfahrens hergestellt werden, sind im wesentlichen nur durch die Löslichkeit von Ammoniumfluorid in dem mindestens einen Lösungsmittel abhängig und können in diesem Rahmen frei gewählt werden. Natürlich ist es auch denkbar, gesättigte Lösungen von Ammoniumfluorid in dem mindestens einen Lösungsmittel herzustellen, wobei es hierbei generell auch denkbar ist, daß soviel Ammoniak und Fluorwasserstoff in das mindestens eine Lösungsmittel eingeleitet werden, daß Ammoniumfluorid als Feststoff ausfällt.

In einer bevorzugten Ausführungsform werden im Rahmen des erfindungsgemäßen Verfahrens hochreine Lösungen von Ammoniumfluorid in dem mindestens einen Lösungsmittel hergestellt, deren Konzentrationen im allgemeinen im Bereich von 0,1 bis 50 Gew.-%, bevorzugt im Bereich von 1 bis 30 Gew.% und besonders bevorzugt im Bereich von 2,5 bis 10 Gew.% liegen.

Um die Bildung von explosionsfähigen Ammoniak-Luft-Gemischen zu vermeiden, ist es im Rahmen des erfindungsgemäßen Verfahrens möglich, den Behälter, in dem der gasförmige Ammoniak in das mindestens eine polare Lösungsmittel eingeleitet wird, in dem gegebenenfalls schon Fluorwasserstoff gelöst ist, zu inertisieren. Dazu ist prinzipiell jedes Inertgas wie unter anderem Stickstoff oder Argon geeignet. Vorzugsweise wird der Behälter bereits intertisiert, bevor er mit Lösungsmittel und gegebenenfalls Fluorwasserstoff befüllt wird.

Als Lösungsmittel, in der die Ammoniumfluoridlösung hergestellt wird, sind prinzipiell alle bereits oben beschriebenen Lösungsmittel denkbar. In einer bevorzugten Ausführungsform werden hierbei wasserfreie Polyole, in einer besonders bevorzugten Ausführungsform wasserfreies Ethylenglykol verwendet.

Ein weiterer Nachteil des bereits oben geschilderten Verfahrens des Standes der Technik, bei dem kristallines Ammoniumfluorid in einem entsprechenden Lösungsmittel gelöst wird, ist in der Tatsache zu sehen, daß es fabrikatorisch äußerst schwierig ist, den Gehalt der herzustellenden Ammoniumfluoridlösung an freiem Fluorwasserstoff reproduzierbar einzustellen, so daß zwei oder mehr Ammoniumfluoridlösungen einen konstanten Wert des Gehaltes an freiem Fluorwasserstoff aufweisen. Für einige industrielle Anwendungen ist jedoch ein konstanter Gehalt an freiem Fluorwasserstoff von entscheidender Bedeutung.

Eine weitere Aufgabe der vorliegenden Erfindung war es demgemäß, ein Verfahren bereitzustellen, das es erlaubt, hochreine Ammoniumfluoridlösungen herzustellen, die einen reproduzierbar einstellbaren, konstanten Gehalt an freiem Fluorwasserstoff aufweisen.

Der Gehalt der erfindungsgemäß hergestellten hochreinen Ammoniumfluoridlösungen an freiem Fluorwasserstoff ist durch das stöchiometrische Verhältnis, in dem gasförmiger Fluorwasserstoff und gasförmiger Ammoniak in das mindestens eine Lösungsmittel eingeleitet werden, in einfacher Art und Weise einstellbar. Durch die genaue Dosiermöglichkeit, die sich durch den Einsatz der gasförmigen Edukte bietet, ist es insbesondere möglich, hochreine Lösungen herzustellen, die einen genau definierten und dabei reproduzierbar einstellbaren Gehalt an freiem Fluorwasserstoff aufweisen. Insbesondere sind dabei hochreine Lösungen von Ammoniumfluorid herstellbar, die freien Fluorwasserstoff in einem Bereich von weniger als 0,01 Gew.-% aufweisen.

Ein technisches Anwendungsgebiet für die erfindungsgemäß hergestellten Lösungen unter Verwendung von gasförmigem Fluorwasserstoff sind Ätzverfahren. Eine weitere Aufgabe der vorliegenden Erfindung war es daher, ein Verfahren bereitzustellen, in dem die hochreinen Lösungen an die gewünschten Anforderungen des jeweiligen Ätzpmzesses anpaßbar sind.

In einer weiteren bevorzugten Ausführungsform des erfindungsgemäßen Verfahrens wird als das mindestens eine weitere Edukt neben Fluorwasserstoff mindestens ein weiteres, bei Ätzverfahren als Reaktivgas wirkgendes Gas eingesetzt. Als Beispiele sind unter anderem etwa Chlorwasserstoff oder Bromwasserstoff zu nennen.

Demgemäß betrifft die vorliegende Erfindung auch ein Verfahren, wie oben beschrieben, das dadurch gekennzeichnet ist, daß als das mindestens eine weitere Edukt gasförmiger Chlorwasserstoff oder gasförmiger Bromwasserstoff oder ein Gemisch daraus eingesetzt werden.

Was die Herstellung dieser Lösungen anbelangt, so ist die Reihenfolge der Zugabe der Gase zu dem mindestens einen polaren Lösungsmittel unkritisch. So ist es möglich, die Gase nacheinander oder auch gleichzeitig, gegebenenfalls räumlich getrennt oder zusammen in einer einzigen Zuleitung, in das mindestens eine polare Lösungsmittel einzuleiten. Weiter ist es möglich, wie bereits oben bei dem Einleiten von Fluorwasserstoff beschrieben, das mindestens eine weitere gasförmige Edukt vor dem Einleiten in das mindestens eine polare Lösungmittel nach den gängigen Verfahren gemäß dem Stand der Technik zu verflüssigen und das mindestens eine verflüssigte Gas in das mindestens eine polare Lösungmittel einzuleiten.

Prinzipiell können alle oben aufgeführten polaren Lösungsmittel für diese bevorzugte Ausführungsform des erfindungsgemäßen Verfahrens verwendet werden, vorausgesetzt, daß das mindestens eine zusätzliche gasförmige Edukt in den Lösungsmitteln löslich ist. In bevorzugten Ausführungsformen werden als polare Lösungsmittel Essigsäure bzw. ein Gemisch aus Essigsäure und Essigester oder ein Gemisch aus DMSO und DMA verwendet. Im Falle, daß ein Gemisch aus DMSO und DMA verwendet wird, ist das Verhältnis, in dem die beiden Komponenten gemischt werden, generell beliebig wählbar. Bevorzugt liegt das stöchiometrische Verhältnis, in dem DMSO und DMA gemischt werden, im Bereich von 30 : 70 bis 70 : 30. In einer besonders bevorzugten Ausführungsform werden hochreine Lösungen von Fluorwasserstoff in einem DMSO / DMA-Gemisch hergestellt, in denen Fluorwasserstoff, DMSO und DMA in gleichen Gewichtsanteilen vorliegen.

In erfindungsgemäß hergestellten hochreineen Lösungen, die neben Fluorwasserstoff auch Bromwasserstoff oder/und Chlorwasserstoff enthalten, liegt das stöchiometrische Verhältnis von Fluorwasserstoff zu Chlorwasserstoff und/oder Bromwasserstoff bevorzugt im Bereich kleiner oder gleich 1, besonders bevorzugt im Bereich kleiner 1.

Im Rahmen des erfindungsgemäßen Verfahrens ist es weiterhin möglich, neben Fluorwasserstoff und gasförmigen Ammoniak auch gasförmigen Chlorwasserstoff oder/und gasförmigen Bromwasserstoff in das mindestens eine polare Lösungsmittel einzuleiten. Hierbei unterliegt die Reihenfolge, in der die Einleitung der einzelnen Komponenten erfolgt, im Prinzip keiner Beschränkung.

Selbstverständlich ist das Anwendungsgebiet der hochreinen Lösungen, in denen neben gasförmigem Fluorwasserstoff als Edukt auch mindestens ein weiteres Reaktivgas eingesetzt wird, nicht auf die oben angesprochenen Ätzverfahren beschränkt.

Prinzipiell bezieht sich der Begriff "Reinheit", wie er hier gebraucht wird, auf sämtliche denkbaren Verunreinigungen, die eine Lösung, die nach dem erfindungsgemäßen Verfahren hergestellt wird, aufweisen kann. Unter anderem seien hier etwa als Verunreinigungen Metallionen, Halogenide wie etwa Chlorid oder Bromid, weitere Anionen wie etwa Nitrat, Phosphat oder Sulfat, organische Verbindungen, ganz allgemein partikuläre Verunreinigungen, Viren, Bakterien und deren Nebenprodukte wie etwa Endotoxine oder Mycotoxine genannt.

Der Begriff "hochrein", wie er hier gebraucht wird, bezeichnet Reinheitsgrade bezüglich einer bestimmten Verunreinigung, die im Bereich von kleiner 1 ppb liegen.

Prinzipiell können nach dem erfindungsgemäßen Verfahren hochreine Lösungen hergestellt werden, die bezüglich aller denkbarer Verunreinigungen hochrein sind. In einer bevorzugten Ausführungsform des erfindungsgemäßen Verfahrens werden hochreine Lösungen hergestellt, die einen sehr niedrigen Gehalt an Metallionen aufweisen.

Im Rahmen des erfindungsgemäßen Verfahrens werden dabei Edukte eingesetzt, deren Verunreinigungsgrad bezüglich aller denkbaren Verunreinigungen so niedrig ist, daß die hochreine Lösung mit der vom Anwender geforderten Reinheit aus den Edukten ohne weiteren Reinigungsschritt herstellbar ist.

Je nach gefordertem Reinheitsgrad der herzustellenden hochreinen Lösung ist es im Rahmen des erfindungsgemäßen Verfahrens denkbar, hochreines Fluorwasserstoffgas und/oder ein oder mehrere hochreine Lösungsmittel einzusetzen. Im Falle, daß mindestens eine weiteres Edukt, wie oben beschrieben, eingesetzt wird, kann auch dieses hochrein sein.

Hinsichtlich der Herstellung der hochreinen Lösungen, die, wie oben beschrieben, sehr niedrige Gehalte an Metallionen aufweisen; wird gasförmiger Fluorwasserstoff eingesetzt, dessen Metallionengehalt kleiner als 1 ppb, bevorzugt kleiner als 100 ppt ist.

Demgemäß betrifft die vorliegende Erfindung auch ein Verfahren, wie oben beschrieben, das dadurch gekennzeichnet ist, daß der verwendete Fluorwasserstoff einen Metallionengehalt von weniger als 1 ppb pro Metall aufweist.

Als Beispiele für Metalle, bezüglich derer die nach dem erfindungsgemäßen Verfahren hergestellte Lösung hochrein ist, seien unter anderem Aluminium, Antimon, Arsen, Barium, Beryllium, Blei, Cadmium, Calcium, Chrom, Eisen, Gallium, Germanium, Gold, Indium, Kalium, Kobalt, Kupfer, Lithium, Magnesium, Mangan, Molybdän, Natrium, Nickel, Platin, Silber, Silicium, Strontium, Thallium, Titan, Vanadium, Wismut, Zink, Zinn oder Zirkonium genannt.

Je nach geforderter Reinheit der herzustellenden Lösung ist es möglich, wenn erforderlich, den Gehalt des mindestens einen polaren Lösungsmittels nach den gängigen Methoden gemäß dem Stand der Technik soweit herabzusetzen, daß dieser im Bereich von kleiner als 1 ppb, bevorzugt kleiner als 100 ppt liegt. Insbesondere ist für das mindestens eine polare Lösungsmittel destillatives Reinigen zu nennen, wobei unter anderem die Reinigung durch herkömmliche Destillation oder durch Destillation unter Verwendung von Mikrowellehstrahlung erwähnt sei.

In einer weiter bevorzugten Ausführungsform des erfindungsgemäßen Verfahrens können damit hochreine Lösungen hergestellt werden, die einen extrem niedrigen Gehalt an Metallionen aufweisen, der im allgemeinen im Bereich von weniger als 1 ppb pro Metall, bevorzugt im Bereich von weniger als 100 ppt pro Metall liegt.

Demgemäß betrifft die vorliegenden Erfindung auch ein Verfahren, wie oben beschrieben, das dadurch gekennzeichnet ist, daß die hochreine Lösung einen Metallionengehalt von weniger als 100 ppt pro Metall aufweist.

Die nach dem erfindungsgemäßen Verfahren hergestellten hochreinen Lösungen können in allen denkbaren technischen Anwendungsbereichen eingesetzt werden. Insbesondere sind Anwendungen auf dem Gebiet der Halbleiter- und Elektronikindustrie, der Analytik sowie der (Bio)pharmazeutik zu nennen.

Demgemäß betrifft die vorliegende Erfindung auch die Verwendung einer hochreinen Lösung, herstellbar nach einem Verfahren gemäß einem der Ansprüche 1 bis 8, auf dem Gebiet der Halbleiter- und Elektronikindustrie, der Analytik, oder der pharmazeutischen oder biopharmazeutischen Anwendungen.

Bevorzugt werden die nach dem erfindungsgemäßen Verfahren hergestellten hochreinen Lösungen als Ätzmittel verwendet. Hierbei kommen vor allem die Vorteile zur Geltung, die sich daraus ergeben, daß beispielsweise bei der erfindungsgemäßen Herstellung der hochreinen Ammoniumfluoridlösungen der Gehalt der Lösungen an freiem Fluorwasserstoff reproduzierbar auf einen konstanten Wert eingestellt werden kann. Damit ist es möglich, das Prozeßfenster für die Ätzrate der Lösung extrem eng zu gestalten.

Demgemäß betrifft die vorliegende Erfindung auch die Verwendung, wie oben beschrieben, die dadurch gekennzeichnet ist, daß die hochreine Lösung als Ätzmittel in der Halbleiter- und Elektronikindustrie eingesetzt wird.

Insbesondere werden die hochreinen Lösungen, die nach dem erfindungsgemäßen Verfahren hergestellt werden, als Ätzmittel zur selektiven Entfernung von organometallischen Resten oder organischen Siliciumresten beim Plasmaätzen im Rahmen der Herstellung von Wafern verwendet. Hinsichtlich dieser Selektivität ist das erfindungsgemäße Verfahren besonders vorteilhaft einzusetzen, da die Selektivität unter anderem durch den gezielten Zusatz von weiteren Reaktivgasen wie etwa Chlorwasserstoff oder Bromwasserstoff, deren Verwendung bereits oben beschrieben wurde, gesteuert werden kann.

In einer weiteren Ausführungsform des erfindungsgemäßen Verfahrens kann der hochreinen Lösung zur Beeinflussung der Ätzselektivität Wasser zugemischt werden. Ein wesentlicher Vorteil des erfindungsgemäßen Verfahrens liegt darin, daß, beispielsweise bei der Herstellung einer hochreinen Ammoniumfluoridlösung unter Verwendung von gasförmigem Fluorwasserstoff, gasförmigem Ammoniak und wasserfreiem Lösungsmittel die hochreine Lösung wasserfrei ist und durch gezielte Zugabe von Wasser im Anschluß an die Herstellung der hochreinen Lösung ein außerordentlich präziser und reproduzierbarer Wassergehalt einstellbar ist.

Selbstverständlich ist es auch möglich, im Anschluß an die erfindungsgemäße Herstellung der wasserfreien hochreinen Lösung ganz allgemein wäßrige Systeme der Lösung zuzugeben. Auch hier liegt der Vorteil unter anderem darin, daß ausgehend von der wasserfreien Lösung der Wassergehalt der herzustellenden Lösung präzise einstellbar ist. Als Beispiel seien unter anderem Säuren wie z.B. Phosphorsäure, wäßrige Salzsäure oder wäßrige Essigsäure genannt.

In einer besonders bevorzugten Ausführungsform der vorliegenden Erfindung wird zusätzlich zu Fluorwasserstoff als Edukt mindestens eine Substanz dem mindestens einen polaren Lösungsmittel zugegeben, die die oberflächenaktiven Eigenschaften der hochreinen Lösung, unter anderem bei der Verwendung als Ätzmittel, beeinflußt. Als Beispiele seien hierbei unter anderem aliphatische oder aromatische Amine genannt. Aliphatische Amine werden bevorzugt mit einer Kettenlänge von 5 bis 12 C-Atomen eingesetzt Die genannten Amine können gegebenenfalls substituiert sein, wobei unter anderem OH-Gruppen oder Halogenidreste als Substituenten denkbar sind.

Um den geforderten Reinheitsgrad der hochreinen Lösung zu gewährleisten, kann es hierbei notwendig sein, die mindestens eine, die Oberflächenaktivität beeinflussende Substanz vor der Verwendung zu reinigen. Hierbei sind alle geeigneten Verfahren nach dem Stand der Technik denkbar.

In den folgenden Beispielen soll das erfindungsgemäße Verfahren näher erläutert werden.

### Beispiele:

### Beispiel 1: Herstellung einer Lösung von Fluorwasserstoff in Ethylenglykol

In einem 1000 ml-Ansatzbehälter wurden 800 g Ethylenglykol vorgelegt. Über einen Injektor wurden ca. 80 g wasserfreie, gasförmige Flußsäure in dem Ethylenglykol kondensiert und gelöst. Dabei wurde die Zunahme des Flußsäuregehalts analytisch überwacht. Bei einem Gehalt von 10 Gew.-% Flußsäure wurde das Einleiten beendet.

Nach beendeter Dosierung wurde die Lösung 1 h über eine Umpumpleitung rezirkuliert und homogenisiert. Die erhaltene Lösung. hatte einen Metallionengehalt von weniger als 100 ppt pro Metall.

### Beispiel 2: Herstellung einer Lösung von Ammoniumfluorid in Ethylenglykol

Ein 1000 ml-Ansatzbehälter wurde 1 h durch Spülen mit Stickstoff inertisiert. Anschließend wurde so verfahren wie in Beispiel 1 angegeben.

Zur dieser Lösung von HF in Ethylenglykol wurde gasförmiger Ammoniak eingeleitet, wobei das molare Verhältnis von Ammoniak und bereits eingeleitetem Fluorwasserstoff 1 : 1 betrug. Dabei wurde die Temperatur durch externe Kühlung und die Dosiergeschwindigeit der Ammoniakeinleitung so geregelt, daß sie den Wert von 30 °C nicht überschritt.

Nachdem die gesamte Menge an Ammoniak eingeleitet war, wurde die Lösung bei eingeschalteter Kühlung noch 30 min rezirkuliert. Die erhaltenen Lösung wies einen Metallionengehalt von weniger als 100 ppt pro Metall auf.

## Patentansprüche

1. Verfahren zur Herstellung einer hochreinen, Fluorwasserstoff oder ein Salz davon oder ein Gemisch aus zwei oder mehr davon enthaltenden Lösung mit einem Metallionengehalt von weniger als 1 ppb pro Metall, bei dem Fluorwasserstoff in mindestens ein polares Lösungsmittel eingeleitet wird, wobei Fluorwasserstoff als Gas oder als verflüssigtes Gas oder als Gemisch aus Gas und verflüssigtem Gas in das Lösungsmittel eingeleitet wird, **dadurch gekennzeichnet, daß** neben Fluorwasserstoff mindestens gasförmiger Ammoniak eingesetzt wird.

2. Verfahren zur Herstellung einer hochreinen, Fluorwasserstoff oder ein Salz davon oder ein Gemisch aus zwei oder mehr davon enthaltenden Lösung mit einem Metallionengehalt von weniger als 1 ppb pro Metall, bei dem Fluorwasserstoff in mindestens ein polares Lösungsmittel eingeleitet wird, wobei Fluorwasserstoff als Gas oder als verflüssigtes Gas oder als Gemisch aus Gas und verflüssigtem Gas in das Lösungsmillel eingeleitet wird, **dadurch gekennzeichnet, daß** neben Fluorwasserstoff mindestens gasförmiger Chlorwasserstoff oder gasförmiger Bromwasserstoff oder ein Gemisch daraus eingesetzt wird.

3. Verfahren nach einem der Ansprüche 1 ole 2 **dadurch gekennzeichnet, daß** das mindestens ein polares Lösungsmittel ausgewählt ist aus der Gruppe, die besteht aus Polyolen, Carbonsäuren, Carbonsäurederivaten, organischen Schwefelverbindungen, aliphatischen oder aromatischen Stickstoffverbindungen und Mischungen aus zwei oder mehr davon.

4. Verfahren nach einem der Ansprüche 1 bis 3, **dadurch gekennzeichnet, daß** der verwendete Fluorwasserstoff einen Metallionengehalt von weniger als 1 ppb pro Metall aufweist.

5. Verfahren nach einem der Ansprüche 1 bis 4, **dadurch gekennzeichnet, daß** die hochreine Lösung einen Metallionengehalt von weniger als 100 ppt pro Metall aufweist.

6. Verwendung der hochreinen Lösung, hergestellt nach einem der Ansprüche 1 bis 5, auf dem Gebiet der Halbleiter- und Elektronikindustrie, der Analytik oder der pharmazeutischen oder biopharmazeutischen Anwendungen.

7. Verwendung der hochreinen Lösung nach Anspruch 6 als Ätzmittel in der Halbleiter- und Elektronikindustrie.

## Claims

1. Method for producing a high purity solution containing hydrogen fluoride or a salt thereof or a mixture of two or more thereof, wherein the hydrogen fluoride is introduced into at least one polar solvent, wherein hydrogen fluoride is introduced into said solvent in the form of gas or as liquified gas or as a mixture of gas and liquified gas, **characterized in that** at least gaseous ammonia is used besides hydrogen fluoride.

2. Method for producing a high purity solution containing hydrogen fluoride or a salt thereof or a mixture of two or more thereof, wherein the hydrogen fluoride is introduced into at least one polar solvent, wherein hydrogen fluoride is introduced into said solvent in the form of gas or as liquified gas or as a mixture of gas and liquified gas, **characterized in that** at least gaseous hydrogen chloride or hydrogen bromide or a mixture thereof is used besides hydrogen fluoride.

3. Method in accordance with any of claims 1 or 2, **characterized in that** the at least one polar solvent is chosen from the group consisting of polyols, carboxylic acids, derivatives of carboxylic acids, organic sulfur compounds, aliphatic or aromatic nitrogen compounds, and mixtures of two or more thereof.

4. Method in accordance with one of the claims 1 to 3, **characterized in that** the used hydrogen fluoride has a metal-ion content of less than 1 ppb per metal.

5. Method in accordance with any one of the claims 1 to 4, **characterized in that** the high purity solution has a metal ion content of less than 100 ppt per metal.

6. Use of a high purity solution, produced in accordance with any one of the claims 1 to 5, in the field of semiconductor or electronics industry, analytic chemistry, or pharmaceutical or biopharmaceutical applications.

7. Use of the solution in accordance with claim 6 as an etching agent in the semiconductor and electronics industry.

## Revendications

1. Procédé de préparation d'une solution de haute pureté, contenant de l'acide fluorhydrique ou un sel de ce dernier ou un mélange d'au moins deux d'entre eux, ayant une teneur en ions métalliques inférieure à 1 ppb (10⁻⁹) par métal, procédé dans lequel l'acide fluorhydrique est introduit dans au moins un solvant polaire, l'acide fluorhydrique étant introduit sous forme d'un gaz, ou d'un gaz liquéfié, ou d'un mélange d'un gaz et d'un gaz liquéfié, dans le solvant, **caractérisé en ce que**, outre de l'acide fluorhydrique, on utilise au moins de l'ammoniac gazeux.

2. Procédé de préparation d'une solution de haute pureté, contenant de l'acide fluorhydrique ou un sel de ce dernier ou un mélange d'au moins deux d'entre eux, ayant une teneur en ions métalliques inférieure à 1 ppb par métal, procédé dans lequel l'acide fluorhydrique est introduit dans au moins un solvant polaire, l'acide fluorhydrique étant introduit sous forme d'un gaz, ou d'un gaz liquéfié, ou d'un mélange d'un gaz et d'un gaz liquéfié, dans le solvant, **caractérisé en ce que**, outre de l'acide fluorhydrique, on utilise au moins de l'acide chlorhydrique gazeux ou de l'acide bromhydrique gazeux, ou un mélange de ceux-ci.

3. Procédé selon l'une des revendications 1 ou 2, **caractérisé en ce qu'**au moins le solvant polaire est choisi dans le groupe consistant en les polyols, les acides carboxyliques, les dérivés d'acide carboxylique, les composés organiques du soufre, les composés aliphatiques ou aromatiques de l'azote et les mélanges d'au moins deux d'entre eux.

4. Procédé selon l'une des revendications 1 à 3, **caractérisé en ce que** l'acide fluorhydrique utilisé présente une teneur en ions métalliques inférieure à 1 ppb par métal.

5. Procédé selon l'une des revendications 1 à 4, **caractérisé en ce que** la solution de haute pureté présente une teneur en ions métalliques inférieure à 100 ppt (10⁻¹²) par métal.

6. Utilisation de la solution de haute pureté préparée selon l'une des revendications 1 à 5 dans le domaine de l'industrie des semi-conducteurs et de l'industrie électronique, de l'analytique, ou des applications pharmaceutiques ou biopharmaceutiques.

7. Utilisation de la solution de haute pureté selon la revendication 6 en tant qu'agent de gravure dans l'industrie électronique et des semi-conducteurs.
